# FASCICULE DE BREVET EUROPEEN

(11) **EP 2 767 504 B1**
(45) Date de publication et mention de la délivrance du brevet: **17.02.2016**
(21) Numéro de dépôt: 14155613.4
(22) Date de dépôt: 18.02.2014
(51) Int. Cl.: B81C 1/00

(54) **Procédé de fabrication d'une structure micromécanique et/ou nanomécanique comportant une surface poreuse**
Verfahren zur Herstellung einer mikro-oder nanomechanischen Struktur, die eine poröse Oberfläche enthält
Process for manufacturing a micro- or nano-mechanical structure comprising a porous surface

(30) Priorité: 19.02.2013 FR 1351400
(43) Date de publication de la demande: 20.08.2014
(73) Titulaire: Commissariat à l'Énergie Atomique et aux Énergies Alternatives, 75015 Paris (FR)
(72) Inventeur: Ollier, Eric, 38100 GRENOBLE (FR)
(74) Mandataire: Ilgart, Jean-Christophe

(56) Documents cités:
- US-A1- 2008 030 825
- US-A1- 2012 115 311
- YONGHA HWANG ET AL: "Porous Silicon Resonators for Improved Vapor Detection", JOURNAL OF MICROELECTROMECHANICAL SYSTEMS, IEEE SERVICE CENTER, US, vol. 21, no. 1, 1 février 2012 (2012-02-01), pages 235-242, XP011403353, ISSN: 1057-7157, DOI: 10.1109/JMEMS.2011.2170819
- STOLYAROVA S ET AL: "Composite porous silicon-crystalline silicon cantilevers for enhanced biosensing", SENSORS AND ACTUATORS B: CHEMICAL: INTERNATIONAL JOURNAL DEVOTED TO RESEARCH AND DEVELOPMENT OF PHYSICAL AND CHEMICAL TRANSDUCERS, ELSEVIER S.A, SWITZERLAND, vol. 131, no. 2, 14 mai 2008 (2008-05-14), pages 509-515, XP022635083, ISSN: 0925-4005, DOI: 10.1016/J.SNB.2007.12.038 [extrait le 2007-12-26]

## Description

### DOMAINE TECHNIQUE ET ART ANTÉRIEUR

La présente invention se rapporte à un procédé de réalisation d'une structure micromécanique et/ou nanomécanique et en particulier de type MEMS et/ou NEMS suspendue comportant des couches de matériaux poreux, ladite structure étant particulièrement adaptée à la réalisation de capteurs.

Les systèmes microélectromécanique ou MEMS Micro-Electro-Mechanical-Systems) sont aujourd'hui couramment employés dans de nombreux produits de notre vie courante. De nouvelles applications apparaissent également notamment du fait de l'apparition des systèmes nanoélectromécaniques ou NEMS (Nano-Electro-Mechanical-Systems) qui offrent de nouveaux avantages du fait de la réduction des dimensions des structures mécaniques. Un des domaines d'intérêt concerne les capteurs d'humidité, les capteurs chimiques ou biologiques qui utilisent le fait que les couches en matériaux poreux favorisent l'interaction entre le capteur et le milieu extérieur par exemple en améliorant l'adsorption de molécules.

Par exemple, le document *"*VLSI silicon multi-gas analyzer coupling gas chromatography and NEMS detectors" A. Niel, V. Gouttenoire, M. Petitjean, N. David, R. Barattin, M. Matheron, F. Ricoul, T. Bordy, H. Blanc,J. Ruellan, D. Mercier, N. Pereira-Rodrigues, G. Costa, V. Agache, S. Hentz, J.C. Gabriel, F. Baieras, C. Marcoux, T. Ernst, L. Duraffourg, E. Colinet, P. Andreucci, E. Ollier, P. Puget and J. Arcamone, IEDM Conference 2011 décrit un exemple de structure NEMS formant un capteur gravimétrique. La structure NEMS comporte une structure vibrante sur la surface de laquelle les molécules de gaz s'adsorbent, ce qui a pour effet de modifier sa masse et donc sa fréquence de résonance. Cette modification est mesurée par l'intermédiaire de gauges piézorésistives et le suivi de la fréquence de résonance de la structure permet donc de suivre les variations de concentration du gaz.

La problématique des systèmes MEMS/NEMS tel que celui décrit dans ce document pour ces applications de capteurs de gaz ou de capteurs biologiques concerne l'interface entre le milieu extérieur et la structure sensible. On cherche à optimiser cette interaction et notamment à favoriser l'adsorption des molécules dans ou sur cette structure tout en maintenant de bonnes caractéristiques mécaniques pour cette structure mécanique.

Des matériaux poreux peuvent être mis en oeuvre pour mieux adsorber les molécules. Le silicium poreux se révèle très intéressant puisqu'il peut offrir des porosités variées. Il peut être microporeux, avec des diamètres de pores inférieur à 2 nm, mésoporeux avec des diamètres de pores comprise entre 2 nm et 50 nm, ou macroporeux avec des diamètres de pores supérieurs à 50 nm.

Le document US 2004/0195096 décrit un procédé de réalisation d'un capteur de gaz comportant des structures de type cantilever ou poutres encastrées-encastrées en technologie de surface entièrement en silicium poreux. La structure mécanique est donc constituée de matériau poreux sur toute son épaisseur. Or le fait que toute la structure soit en matériau poreux peut être défavorable pour obtenir des propriétés mécaniques de qualité, par exemple pour une structure résonante.

Le document US 2011/0221013 décrit l'encapsulation de structure MEMS par un matériau poreux. Mais la formation de la couche poreuse ayant lieu sur la structure mécanique déjà formée, il n'est pas possible de localiser la couche poreuse.

Le document *"*Composite porous silicon-crystalline silicon cantilevers for enhanced biosensing", S. Stolyarova, S. Cherian, R. Raiteri, J. Zeravik, P. Skladal, Y. Nemirovsky, Sensors and Actuators B 131 (2008) 509-515 décrit la formation d'une couche de silicium poreux sur la surface inférieure d'une structure mécanique mobile en silicium monocristallin qui a été formée préalablement à partir d'un substrat SOI. Le silicium poreux formé permet d'immobiliser une large variété de substances chimiques et/ou biologiques conduisant à des sensibilités nettement améliorées.

Le document "Porous Silicon Resonators for Improved Vapor Detection", Journal of Micromechanical systems 21 (2012) 235-242 décrit également un détecteur de vapeur micromécanique ayant une surface de détection en silicium poreux.

La couche poreuse n'est pas localisée au niveau de la structure mécanique libérée. En effet le silicium poreux étant formé après l'étape de formation de la structure mécanique, l'ensemble de cette structure où le silicium est apparent est recouvert de silicium poreux. Or ceci n'est pas souhaitable pour de nombreuses structures MEMS/NEMS dans lesquelles les parties d'actionnement et/ou détection sont des structures également en partie mobiles ou pour les structures comportant une partie résonante. En effet, dans le cas de moyens d'actionnement et/ou détection de type capacitif, les électrodes seraient recouvertes de silicium poreux; dans le cas d'une détection piézorésistive, les gauges de contraintes seraient recouvertes, voire formées par du silicium poreux et pour les structures résonantes par des faces recouvertes, elles aussi, de silicium poreux. Les facteurs de qualité sont susceptibles d'être dégradés du fait des pertes d'énergie dues à la surface poreuse.

Or, pour toutes ces parties il est préférable pour assurer un haut niveau de performances de disposer du silicium monocristallin présentant des très bons états de surface qui sont issus des gravures du matériau silicium monocristallin, ou plus généralement que ces parties soit en matériaux monocristallin ou polycristallin présentant des très bons états de surface et non en un matériau poreux.

### EXPOSÉ DE L'INVENTION

C'est par conséquent un but de la présente invention d'offrir un procédé de fabrication d'une structure micromécanique et/ou nanomécanique et plus particulièrement d'une structure microélectromécanique et/ou nanoélectromécanique (MEMS et/ou NEMS) présentant de très bonnes propriétés mécaniques et une surface importante en matériau poreux apte notamment à adsorber et/ou absorber des espèces d'intérêt.

Le but précédemment énoncé est atteint par un procédé permettant de réaliser des structures mécaniques comportant un matériau intercalaire entre deux couches en matériaux présentant une porosité supérieure à celle du matériau intercalaire, le matériau intercalaire présentant les propriétés mécaniques et les couches en matériaux poreux étant destinées à l'adsorption ou l'absorption des espèces d'intérêt.

D'autres propriétés des couches poreuses par exemple en termes d'isolation électrique et/ou d'isolation thermique rendent l'invention intéressante. Ces propriétés peuvent permettre d'utiliser la structure pour d'autres applications que celles dans lesquelles des espèces d'intérêt sont adsorbés ou absorbés.

A cet effet le procédé comporte les étapes suivantes effectuées sur un substrat comportant une couche sacrificielle :
- formation d'une première couche dont au moins une partie est en un matériau poreux sur la couche sacrificielle,
- formation d'une couche en un ou plusieurs matériaux présentant les propriétés mécaniques souhaitées de la structure,
- formation d'une deuxième couche, dont au moins une partie est en en un matériau poreux, sur la couche en un ou plusieurs matériaux présentant les propriétés mécaniques souhaitées de la structure,
- formation de la structure mécanique dans les couches précédentes et libération de la structure mécanique par retrait au moins partiel de la couche sacrificielle.

Grâce à ce procédé, au moins une partie des faces inférieure et supérieure de la structure mécanique peuvent être recouvertes de matériau poreux, la surface d'absorption est donc augmentée et les propriétés mécaniques sont assurées puisque la couche formant la structure mécanique n'est pas affectée.

De manière très avantageuse, les zones poreuses des première couche et deuxième couche sont formées de façon localisées sur le substrat de sorte qu'en fin de procédé, seule la structure mécanique suspendue ou une partie de cette structure comporte des zones en matériau poreux. Pour cela, des masques sont mis en oeuvre pour réaliser les première et deuxième couches qui sont formées ou gravées afin de conserver le matériau poreux dans des zones localisées. Ainsi les moyens d'actionnement et/ou de détection peuvent être libres de la présence de matériau poreux et ne voient pas leurs performances dégradées par la présence de matériau poreux.

Dans un exemple très avantageux, les première et deuxième couches poreuses sont en silicium poreux et la couche assurant les propriétés mécaniques est en silicium monocristallin.

La présente invention a alors pour objet un procédé de fabrication d'une structure micromécanique et/ou nanomécanique comportant les étapes suivantes, à partir d'un élément comportant un substrat support et une couche sacrificielle :
a) formation d'une première couche dont au moins une partie est poreuse,
b) formation, sur la première couche, d'une couche assurant les propriétés mécaniques de la structure, dite couche intercalaire,
c) formation, sur la couche intercalaire, d'une deuxième couche dont au moins une partie est poreuse,
d) formation de ladite structure dans l'empilement de la première couche, de la couche intercalaire et de la deuxième couche,
e) libération de ladite structure par retrait au moins partiel de la couche sacrificielle.

On entend par couche dans la présente demande, une couche homogène de matériau ou une couche hétérogène composée de plusieurs matériaux. Par ailleurs, la couche dite intercalaire est de préférence non poreuse ou de porosité inférieure à celles des première et deuxième couches mais elle pourrait éventuellement être poreuse si elle assure sa fonction mécanique.

Dans un exemple avantageux, la partie poreuse de la première couche peut se superposer au moins partiellement à la partie poreuse de la deuxième couche. Par exemple, les première et deuxième couches poreuses peuvent être localisées différemment l'une de l'autre. En variante, une seule des deux couches est localisée.

De manière avantageuse, la partie poreuse de la première couche et/ou la partie poreuse de la deuxième couche peuvent présenter une porosité de type ouverte, i.e. les pores communiquent entre eux pour permettre la circulation d'espèces gazeuses dans la ou les couches poreuses, dans certaines applications, comme par exemple les applications capteur de gaz ou d'humidité

De préférence, les matériaux des première et/ou la deuxième couches poreuses sont choisis indépendamment parmi les semi-conducteurs, les diélectriques et notamment diélectriques à faible permittivité.

Les première et deuxième couches peuvent présenter des propriétés hydrophiles ou hydrophobes. Pour cela, elles peuvent avoir subi des traitements par exemple par plasma pour modifier leur propriété chimique en surface ou en profondeur.

Par exemple, l'étape a) et/ou l'étape c) comporte(nt) une étape de dépôt, de croissance ou de report d'une couche sur la couche sacrificielle et/ou sur la couche intercalaire.

De manière avantageuse, les parties poreuses de la première et/ou de la deuxième couche sont localisées, la localisation étant obtenue par exemple par dépôt, croissance, report localisés ou par gravure localisée.

Il sera compris que la porosité de la couche pourrait être intrinsèque à la couche.

L'étape a) et/ou l'étape c) peut/peuvent comporter une étape de porosification d'au moins une partie de ladite couche. Pour cela, par exemple préalablement à l'étape de porosification est réalisée un masque sur ladite couche de sorte à localiser au moins une zone de matériau à rendre poreuse. Le masque peut être un masque dur en nitrure de silicium. La porosification peut être obtenue par voie électrochimique (anodisation) ou par gravure en phase vapeur (stain-etching).

Le matériau de la première et/ou deuxième couche peut être un semi-conducteur dopé P, de préférence P+.

Le matériau de la couche intercalaire est avantageusement un matériau monocristallin.

L'étape b) peut comporter l'étape de croissance épitaxiale de la couche intercalaire sur la première couche.

L'étape d) de formation de ladite structure dans l'empilement de la première couche, de la couche intercalaire et de la deuxième couche peut comporter une étape de lithographie et de gravure anisotrope dudit empilement.

La libération de la structure peut être obtenue par gravure isotrope de la couche sacrificielle.

Le matériau de la couche sacrificielle est choisi de préférence différent de celui de la première couche, de celui de la deuxième couche et de la couche intercalaire.

Par exemple, le matériau de la couche sacrificielle peut subir un traitement, par exemple un dopage.

Dans un exemple de réalisation, la première et la deuxième couche sont en silicium poreux et la couche intercalaire est en silicium monocristallin.

Dans un autre exemple de réalisation, la première et la deuxième couche sont en SiGe poreux et la couche intercalaire est en SiGe non poreux.

Dans un autre exemple, la première et la deuxième couche sont en SiC poreux et la couche intercalaire est en SiC non poreux.

De préférence, la structure comporte une partie fixe et une partie suspendue sur un support et des moyens d'actionnement de la partie suspendue et des moyens de détection du déplacement de la partie suspendue, la partie suspendue étant munie sur une première face en regard du support et sur une deuxième face opposée à la première face de au moins une zone poreuse formées lors des étapes a) et c).

Les moyens d'actionnement sont par exemple électrostatiques et comportent des électrodes situées sur des flancs des parties fixes et suspendues non munis de zone poreuse.

Dans un exemple de réalisation, les moyens de détection sont capacitifs et comportent des électrodes situées sur des flancs des parties fixes et suspendues non munis de zone poreuse. Dans un autre exemple de réalisation, les moyens de détection comportent des jauges piézorésistives s'étendant entre la partie fixe et la partie suspendue, lesdites jauges n'étant pas munies de zone poreuse.

On peut former en outre une ou plusieurs couches poreuses latérales sur des flancs de la partie suspendue et/ou de la partie fixes.

La structure micromécanique et/ou nanomécanique ainsi obtenue peut être destinée à la fabrication d'un capteur chimique et/ou biologique, et/ou d'humidité les zones poreuses étant destinées à adsorber des molécules d'intérêt.

### BRÈVE DESCRIPTION DES DESSINS

La présente invention sera mieux comprise à l'aide de la description qui va suivre et des dessins en annexes sur lesquels :
- les figures 1A à 1H sont des représentations schématiques des différentes étapes d'un exemple de procédé de réalisation selon l'invention d'une structure mécanique MEMS et/ou NEMS comportant au moins une couche en matériau poreux sur sa face inférieure et sur sa face supérieure,
- les figures 2A et 2B sont des vues de dessus et en coupe transversale respectivement d'un exemple de structure obtenu grâce au procédé selon l'invention, les couches en matériau poreux recouvrant toute la surfaces des faces intérieure et supérieure de la structure,
- les figures 2C et 2D sont des vues de dessus et en coupe transversale respectivement d'une variante de la structure des figures 2A et 2B,
- les figures 3A et 3B sont des vues de dessus et en coupe transversale respectivement d'un exemple de structure obtenu grâce au procédé selon l'invention, les zones en matériau poreux étant localisées sur les faces intérieure et supérieure de la structure,
- les figures 4A et 4B, 5A et 5B et 6A et 6B sont des vues de dessus et en coupe transversale respectivement d'autres exemples de structures obtenus grâce au procédé selon l'invention, les zones en matériau poreux étant localisées sur les faces intérieure et supérieure de la structure.

### EXPOSÉ DÉTAILLÉ DE MODES DE RÉALISATION PARTICULIERS

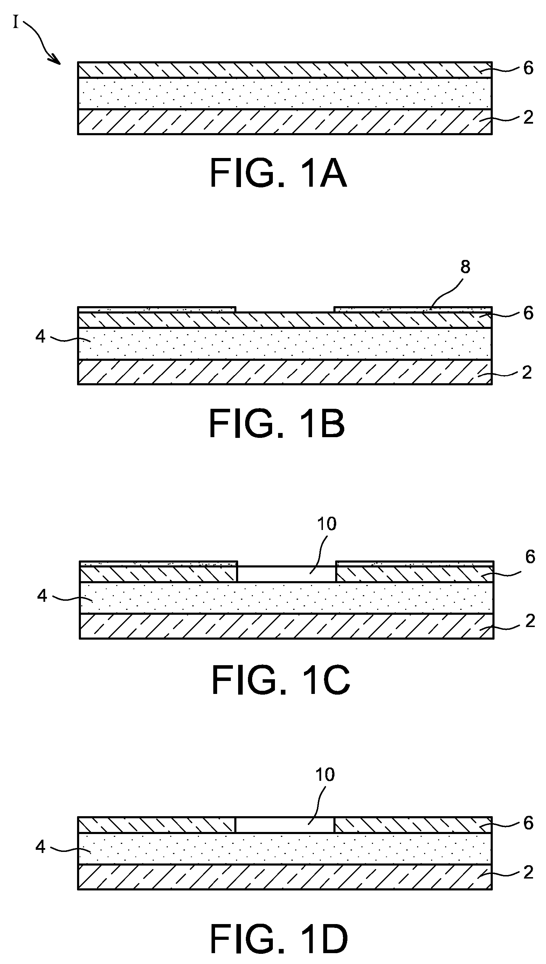

Les figures 1A à 1H représentent les étapes d'un exemple de procédé de fabrication d'une structure mécanique de type MEMS et/ou NEMS comportant des couches de matériaux poreux sur sa face supérieure et sa face inférieure.

Dans la présente demande, la face inférieure de la structure est la face de la structure faisant face au substrat sur lequel est réalisée la structure et la face supérieure de la structure est orientée vers l'extérieur de la structure et est opposée à la face inférieure.

A des fins de simplicité de la description du procédé de réalisation, les couches en matériau poreux sont en silicium poreux et la structure est en silicium monocristallin. Il sera décrit dans la suite de la description d'autres exemples de matériaux pour ces couches.

A partir d'un élément I comportant un substrat 2 par exemple en silicium, une couche sacrificielle 4, par exemple en oxyde de silicium 4 tel que du BOX (Buried oxyde), formée sur le substrat 4 et une couche de silicium 6 formée sur la couche sacrificielle 4. L'élément I peut être une plaque SOI ("Silicon on insulator" en terminologie anglaise) ou silicium sur isolant. La couche de silicium 6 a par exemple une épaisseur comprise entre quelques dizaines de nm et quelques centaines de nm.

Cet élément I est représenté sur la figure 1A.

La première couche en matériau poreux est réalisée dans la couche 6. De préférence, le silicium est dopé P+, ce qui facilite la formation de silicium poreux par voie électrochimique (anodisation). Il peut également être de type P, dopage pour lequel un procédé de gravure par voie électrochimique mettra également en oeuvre de façon préférentielle une illumination en face arrière pour permettre la circulation de porteurs vers la zone à porosifier. En variante, un autre type de dopage, même un dopage N, peut être effectué en fonction du procédé de porosification mis en oeuvre.

Lors d'une étape suivante, la zone de la couche 6 où l'on souhaite réaliser la portion poreuse est délimitée, au moyen d'un masque formé sur la couche 6, par exemple un masque dur. Le matériau du masque est choisi de sorte à résister aux techniques de porosification. Par exemple le masque est réalisé en nitrure de silicium qui résiste à la dissolution anodique en présence d'acide fluorhydrique.

En variante, d'autres couches peuvent être utilisées comme masque dur en fonction des techniques de porosification utilisées : Si₃N₄, SiO₂, SiGe, SiC, le silicium polycrystallin et leurs combinaisons. En variante, on peut également mettre en oeuvre des techniques d'implantation ionique pour rendre le matériau du masque résistant à la technique de porosification.

Le masque est réalisé par dépôt d'une couche 8 d'un ou d'une combinaison des matériaux mentionnés ci-dessus sur toute la surface de la couche de silicium 6 et par gravure de celle-ci au moyen de techniques de photolithogravure classiques pour ouvrir les zones 10 donnant accès à la couche de silicium 6.

L'élément ainsi formé est représenté sur la figure 1B.

Lors d'une étape suivante, a lieu la porosification de la zone 10 de la couche de silicium 6. Une technique de porosification est alors mise en oeuvre. Par exemple on peut utiliser une porosification par voie électrochimique (anodisation) dans laquelle la porosification est obtenue par dissolution anodique en présence d'acide fluorhydrique. Cette technique présente l'avantage de permettre l'obtention d'épaisseurs et de porosités variées selon le dopage de la couche dans laquelle est réalisée la porosité et selon les conditions du procédé.

Les épaisseurs peuvent varier de quelques dizaines de nanomètres à plusieurs dizaines de micromètres. La taille des pores peut elle varier de quelques nanomètres à quelques micromètres, donnant ce que l'on appel des siliciums microporeux, mésoporeux ou macroporeux. Les conditions d'anodisation, par exemple la concentration en acide fluorhydrique, la densité de courant, la durée, ainsi que le dopage, i.e. une absence de dopage, un dopage N ou P et la concentration en dopants, de la couche dans laquelle est formée la porosité (ici la couche 6) permettent de contrôler les caractéristiques de la couche poreuse.

La porosification a lieu de préférence dans toute l'épaisseur de la couche 6. Ainsi la zone 10 s'étend de la couche sacrificielle à la face libre de la couche 6.

D'autres techniques de porosification peuvent être utilisées, par exemple la technique de « stain-etching » décrite par exemple dans le document : « Vapor-etching-based porous silicon formation », M. Saadoun, N. Mliki, H. Kaabi, K. Daoubi, B. Bessais, H. Ezzaouia, R.Bennaceur, Vapour-etching-based porous silicon: a new approach, Thin Solid Films 405 (2002) 29-34*.* Cette technique, également appelée Reactive Induced Vapor Phase Stain Etch (RIVPSE), consiste à exposer la couche que l'on veut rendre poreuse à des vapeurs produites par la gravure de silicium dans un mélange HF : HNO3: CH3COOH. Un des intérêts de cette technique réside dans le fait qu'il n'est pas nécessaire de réaliser de contacts électriques entre les faces avant et arrière du substrat ni de tremper l'élément dans une solution liquide comme c'est le cas dans la technique électrochimique et qu'il est plus aisé de former du silicium poreux sur tout type de substrat par exemple du SOI. La gravure chimique, utilisant le plus souvent un électrolyte à base d'acide fluorhydrique et d'acide nitrique, présente l'avantage d'être une technique simple et économique.

L'élément ainsi formé est représenté sur la figure 1C.

Lors d'une étape suivante, le masque est éventuellement éliminé par exemple par gravure.

L'élément ainsi formé est représenté sur la figure 1D.

Lors d'une étape suivante, une couche de silicium monocristallin 12 est formée sur la couche 6 munie de la zone poreuse 10, dans laquelle la structure mécanique sera réalisée.

Par exemple, la couche 12 est formée par croissance épitaxiale sur la couche 6 munie de la zone poreuse 10. La couche 12 a par exemple une épaisseur comprise entre quelques dizaines de nm à quelques centaines de nanomètres. Une telle croissance épitaxiale est par exemple décrite dans le document EP 2364953. Cette croissance est obtenue par la technique de croissance épitaxiale pour le silicium qui est bien connue de l'homme du métier. Préalablement à cette croissance, la morphologie du Si poreux est préalablement bien stabilisée la par exemple par un traitement thermique sous vide.

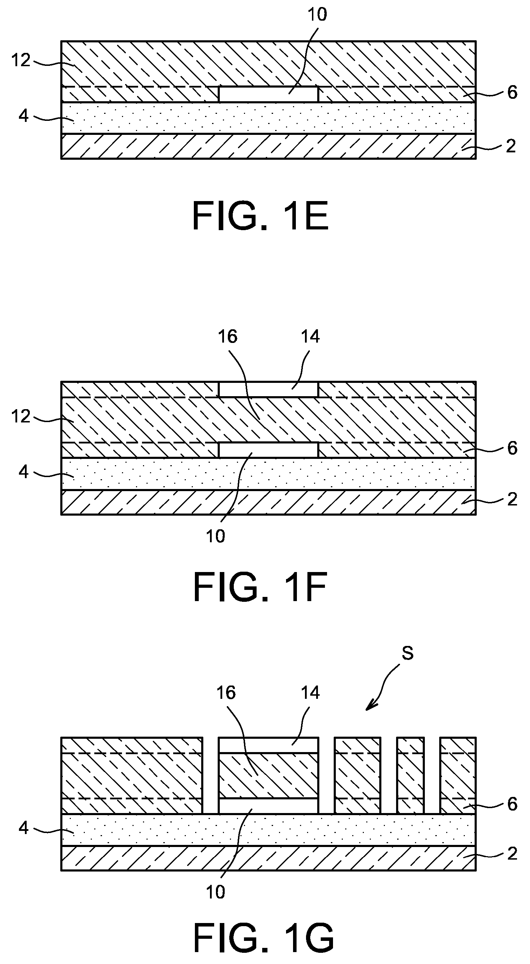

L'élément ainsi formé est représenté sur la figure 1E.

Lors d'une étape suivante, une deuxième zone 14 de silicium poreux est réalisée dans la couche 12 par exemple à l'aplomb de la première zone 10 en silicium poreux. Pour cela, les mêmes étapes que pour la formation de la première zone 10 sont mises en oeuvre i.e. réalisation d'un masque sur la couche 12 et porosification de la zone de la couche 12 accessible. Contrairement à la réalisation de la zone 10, la réalisation de la zone 14 ne se fait pas dans toute l'épaisseur de la couche de silicium 12, mais sur une partie de l'épaisseur de celle-ci. L'épaisseur de la zone 14 peut être égale ou différente de celle de la zone 10. Le contrôle de l'épaisseur de la couche 14 se fait par exemple au temps.

Les zones poreuses 10 et 14 peuvent être à l'aplomb l'une de l'autre ou non. Par exemple si l'on veut maximiser la surface poreuse, il est intéressant de recouvrir partiellement les moyens de détection, tels que les gauges piézorésistives par exemple, en augmentant la surface poreuse supérieure, tout en évitant d'avoir une couche poreuse inférieure au niveau de ces structures pour assurer une qualité cristalline optimale au niveau de ces structures. En effet, de cette manière, le matériau qui va constituer ces structures pourrait être généré à partir, non pas de Si poreux, mais de Si monocristallin dans le cas où la couche poreuse inférieure a été réalisée sur une couche de Si monocristallin, ce qui assure une meilleure qualité cristalline pour ces structures.

Le masque est ensuite éliminé par gravure.

L'élément ainsi formé est représenté sur la figure 1F.

On obtient alors une couche de silicium monocristallin munie dans certaines zones d'empilements de deux zones de silicium 10, 14 poreux de part et d'autre d'une zone de silicium monocristallin 16. Cette zone sera désignée couche intercalaire 16.

Il peut être prévu une étape de planarisation par exemple par voie mécano-chimique pour assurer une bonne planéité de l'ensemble.

En variante, la localisation des zones poreuses peut également être obtenue en réalisant une première et/ou une deuxième couche entièrement poreuse et ensuite en gravant la première et/ou la deuxième couche poreuse pour ne conserver des zones poreuses qu'aux endroits désirés. La gravure peut être localisée par exemple par une étape de lithographie.

La couche intercalaire 16 peut être réalisée par croissance, dans ce cas la croissance se fait sur la couche sacrificielle d'oxyde, le silicium est alors polycristallin, par dépôt ou par report. Dans ce dernier cas, une étape de comblement entre les zones poreuses, par exemple par de l'oxyde, et une étape de planarisation sont effectuées avant le report de la couche intercalaire. La couche intercalaire peut alors être du Si monocristallin ou du Si polycristallin.

La localisation des zones poreuses est plus particulièrement intéressante pour la couche supérieure 12.

Lors d'une étape suivante, on réalise la structure NEMS et/ ou MEMS dans l'empilement de couches.

Pour cela, on définit les motifs de la structure par photolithographie dans une résine et ensuite par gravure anisotrope on définit des motifs dans l'empilement.

Lors de la réalisation de la structure NEMS et/ou MEMS, une partie des motifs est réalisée dans le silicium monocristallin et une autre partie des motifs est réalisée dans l'empilement des zones poreuses 12, 14 et de la couche intercalaire 16, ce qui permet d'obtenir une structure avec des parties uniquement en silicium monocristallin et d'autres en silicium monocristallin recouvert de silicium poreux sur ses faces inférieure et supérieure.

Il sera compris que la gravure permettant de définir la structure mécanique peut être réalisée à l'intérieur ou en périphérie des zones de matériau poreux.

L'élément ainsi formé est représenté sur la figure 1G.

Dans l'exemple représenté et de manière avantageuse, les éléments gravés comportant des zones poreuses comportent sur leur périphérie du silicium monocristallin. En effet, de préférence la gravure qui est utilisée pour définir la structure mécanique s'effectue pour tous les éléments de la structure dans un matériau homogène qui est le silicium monocristallin; ainsi il n'y a pas de différences de vitesse de gravure. Néanmoins, on peut également envisager de réaliser cette gravure dans le silicium poreux à certains endroits pour maximiser la couverture de la surface de la structure mécanique par le matériau poreux, dans ce cas il sera alors tenu compte d'éventuelles différences de vitesse de gravure entre les parties en Si monocristallin et les parties en Si poreux.

Lors d'une étape suivante, si des contacts électriques sont requis, on réalise des reprises de contacts et lignes de connexions métalliques à la surface de la couche 12, par exemple en AISi qui est un métal qui présente l'avantage de résister à la gravure à l'acide fluorhydrique utilisé pour la libération de la structure mécanique.

Lors d'une étape suivante, la structure mécanique est libérée, par exemple par une gravure isotrope au temps de la couche sacrificielle, par exemple avec l'acide fluorhydrique.

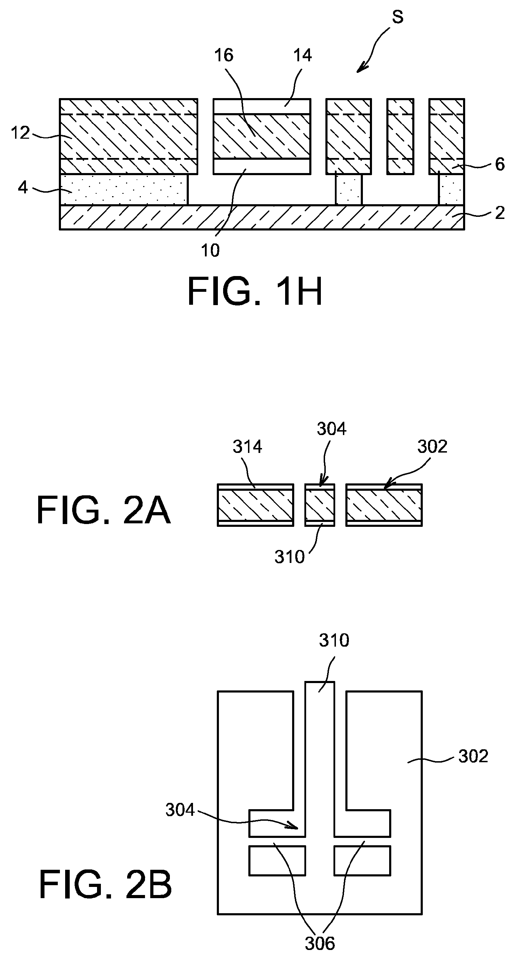

L'élément ainsi formé est représenté sur la figure 1H. La structure comporte une partie recouverte de silicium poreux sur ses faces inférieure et supérieure et une partie en silicium monocristallin uniquement.

La structure mécanique suspendue peut être mobile ou non dans l'application, et dans le cas où elle est mobile, le déplacement peut se faire dans le plan du substrat ou bien perpendiculairement au plan du substrat ou encore dans toute autre direction.

Ainsi, grâce au procédé selon l'invention, on réalise une structure mécanique comportant une surface maximisée par exemple destinée à l'adsorption d'espèces d'intérêt formée par les deux zones poreuses sur les deux faces de la couche en silicium monocristallin et offrant des propriétés mécaniques conservées grâce aux parties uniquement en silicium monocristallin.

Selon une variante de procédé, les étapes de localisation des zones poreuses sont omises, i.e. les étapes de réalisation des masques sur la couche de silicium monocristallin 6 formée au-dessus de la couche sacrificielle et sur la couche de silicium monocristallin 12. On réalise alors des zones poreuses 110, 114 sur toute la surface de couche 6 et 12 respectivement. La structure mécanique ainsi formée comporte alors uniquement un empilement de deux couches poreuses séparées d'une couche de silicium monocristallin. De préférence la gravure des motifs de la structure mécanique se fait par gravure ionique réactive ou RIE ("Reactive ion etching" en terminologie anglaise) qui est bien adaptée à la gravure du silicium poreux.

Selon une autre variante de réalisation, la couche de silicium monocristallin est remplacée par une couche 212 en silicium polycristallin. Celle-ci est par exemple formée par épitaxie sur la couche munie de la zone 10 de silicium poreux. Des précautions particulières pour la croissance du silicium sur la zone poreuse 10 ne sont pas requises, contrairement à la croissance de silicium monocristallin. Les étapes de réalisation des masques pour localiser ou non les zones poreuses peuvent avoir lieu ou être omises comme dans la variante décrite ci-dessus.

Il peut être envisagé de ne localiser que l'une des deux couches de silicium poreux seulement, par exemple uniquement dans la couche inférieure. Ceci présente un avantage lorsqu'on souhaite maximiser la couverture de la structure mécanique par le matériau poreux tout en assurant d'excellentes propriétés mécaniques à la structure. On recouvre alors toute la structure mécanique de matériau poreux sur sa surface supérieure, mais on évite de mettre du silicium poreux sur la surface inférieure en dessous de certaines parties importantes de la structure mécanique, telles que les ancrages, gauges piézorésistives, etc.

Les zones poreuses 10 et 14 peuvent être en matériaux différents et présenter des épaisseurs différentes, et/ou des formes différentes.

Selon une autre variante, on peut prévoir que d'autres surfaces de la structure mécanique que les faces inférieure et supérieure soient recouvertes de matériau poreux, comme par exemple les surfaces latérales afin de maximiser encore plus la surface poreuse ou de bénéficier des propriétés d'anti-stiction des surfaces qui ont été rendues poreuses.

Ces zones latérales poreuses peuvent être réalisées avec les mêmes techniques que précédemment, par exemple en soumettant la structure une fois formée à des vapeurs permettant de rendre poreuses les surfaces de silicium exposées. De telles structures seront décrites par la suite.

La structure mécanique peut être réalisée avec d'autres matériaux que le silicium. A titre d'exemple non limitatif, elle peut être réalisée en SiGe, les zones poreuses 10 et 14 étant en SiGe poreux et la couche intercalaire en SiGe non poreux ou en SiC les zones poreuses 10 et 14 étant en SiC poreux et la couche intercalaire en SiC non poreux. Néanmoins, dans le cas du SiC, celui-ci présente des joints de grains ou une structure amorphe, il peut être alors plus difficile de contrôler le courant dans le cas du procédé de formation de la porosité par anodisation.

Dans le cas du silicium, celui ci peut être monocristallin ou polycristallin.

Dans l'exemple décrit ci-dessus, l'élément de départ est un substrat SOI, mais ceci n'est en aucun cas limitatif. En effet, afin de réaliser le procédé selon l'invention, l'élément de départ comporte au moins un substrat formant support et une couche en matériau apte à former une couche sacrificielle. Le matériau de la couche sacrificielle est de préférence de nature différente des matériaux des couches poreuses et de la couche 12 pour assurer une très bonne sélectivité lors de l'étape de libération de la structure mécanique. Le matériau de la couche sacrificielle est par exemple en SiO₂ pour une structure mécanique en silicium, ou encore en SiGe pour une structure mécanique en silicium.

La couche sacrificielle pourrait en variante être réalisée dans un matériau de même nature que celui de la structure mécanique, par exemple il pourrait s'agir de silicium ayant subi un traitement particulier modifiant sa vitesse de gravure par rapport aux autres matériaux de la structure, ce traitement peut par exemple être un dopage particulier du silicium.

Il est à noter que la couche sacrificielle peut ne pas recouvrir toute la surface du substrat mais uniquement une partie qui correspond à la zone de libération de la structure mécanique.

Nous allons décrire un autre exemple de procédé selon l'invention dans lequel l'élément de départ n'est pas un substrat SOI.

Dans cet exemple, l'élément de départ est un substrat en un matériau semi-conducteur, sur lequel est réalisée une couche en un matériau sacrificiel réalisée par exemple par oxydation du substrat ou par dépôt.

Lors d'une étape suivante, une couche de matériau semi-conducteur, par exemple du silicium, est formée sur la couche sacrificielle par exemple par dépôt. Cette couche peut être également formée par épitaxie ou bien rapportée par une technique de report de couche par scellement moléculaire, anodique ou autre, comme il est connu dans l'état de l'art (comme décrit dans la suite pour la couche intercalaire). Cette couche est ensuite rendue poreuse. Dans l'exemple décrit, les zones poreuses ne sont pas localisées. Mais une telle localisation peut être obtenue en utilisant un masque préalablement à l'étape de porosification comme décrit ci-dessus. La porosification est réalisée comme décrit ci-dessus également.

Lors d'une étape suivante, on réalise la couche intercalaire soit par un dépôt, par exemple du silicium polycristallin, soit par épitaxie, par exemple si la couche précédente est en matériau monocristallin et que l'on désire conserver cette caractéristique. Mais on peut également utiliser des techniques de report de couche par des techniques de scellement wafer-wafer, par exemple en utilisant des scellements moléculaires, anodiques, etc.; et des techniques de grinding permettant de retirer les wafer « poignée » qui servaient de support mécanique lors des opérations de manipulation nécessaires au transfert des couches... Des techniques de poignées temporaires peuvent aussi être utilisées pour ces transferts de couches comme il est connu dans l'état de l'art de report de wafers et de couches.

Lors d'une étape suivante, on réalise une nouvelle couche poreuse. Celle-ci, peut être obtenue en rendant poreux la couche intercalaire sur une partie de son épaisseur, soit en formant directement une couche poreuse sur la couche intermédiaire soit en formant une couche que l'on rend poreuse ensuite, ou encore rapporter une couche poreuse ou à rendre poreuse par des techniques de scellement wafer-wafer comme indiqué ci-dessus. Comme mentionné ci-dessus, dans cet exemple de procédé, il n'est pas prévu de localiser les zones poreuses. Mais ceci peut être obtenu au moyen d'un masque formé préalablement à la porosification. Cette étape peut s'appliquer à la formation de la première couche sur la couche sacrificielle.

Lors d'une étape suivante, la structure mécanique est réalisée dans l'empilement de manière similaire à la description ci-dessus.

Lors d'une étape suivante, la structure mécanique est libérée par retrait de tout ou partie de la couche sacrificielle par exemple avec de l'acide fluorhydrique dans le cas d'une couche en oxyde.

Il sera compris que les étapes de formation des zones poreuses décrites ci-dessus s'appliquent également au procédé décrit en relation avec les figures 1A à 1H.

Nous allons maintenant décrire des structures mécaniques obtenues grâce au procédé selon l'invention.

Sur les figures 2A et 2B, on peut voir une structure du type poutre encastrée-libre, comportant une partie fixe 302, une partie mobile 304 en forme de poutre suspendue par une extrémité longitudinale sur la partie fixe, des moyens d'actionnement de type électrostatique formés par des électrodes portées par la partie fixe en regard des flancs latéraux de la poutre 304. La poutre est alors excitée dans le plan mais elle peut se déplacer dans n'importe quelle direction en fonction du mode de résonance excité notamment. La structure comporte également des moyens de détection pour détecter le déplacement de la poutre formés par deux jauges piézorésistives 306 montées en différentiel. Dans cet exemple la structure est recouverte sur toute sa face inférieure et sur toute sa face supérieure par une couche poreuse 310, 314. Lors de la fabrication, les zones poreuses n'ont pas été localisées. Dans cet exemple de réalisation, les moyens d'actionnement restent libres de matériau poreux sur leurs flancs.

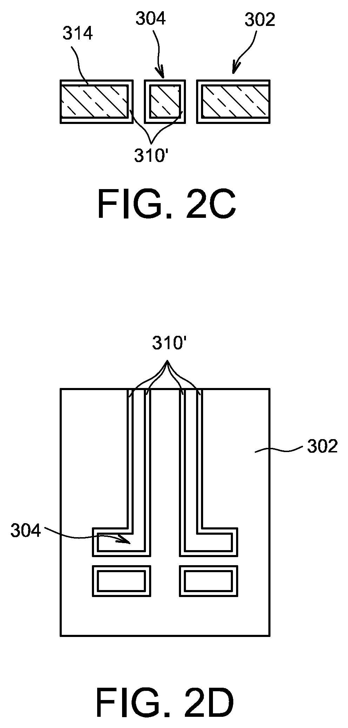

Sur la figures 2C et 2D, on peut voir une variante de la structure des figures 2A et 2B, dans laquelle les surfaces latérales de la partie mobile 304 et des faces en regard de la partie fixe 302 comportent une couche poreuse 310'.

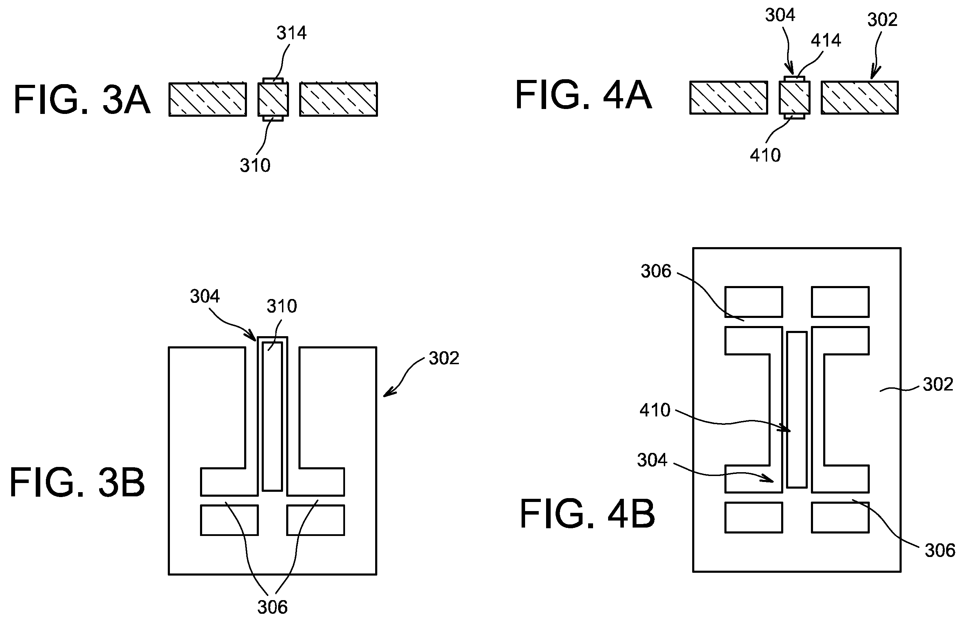

Sur les figures 3A et 3B, on peut voir la même structure que celle des figures 2A et 2B, cependant elle diffère en ce que les zones poreuses sont localisées sur la partie mobile. Les parties d'actionnement et de mesure ne sont pas recouvertes de matériau poreux.

Sur les figures 4A et 4B, on peut voir une structure dans laquelle la partie libre est du type poutre encastrée-encastrée au niveau de ses deux extrémités longitudinales, et les moyens de mesure comportent deux paires de jauges piézorésistives 306, chaque paire de jauges étant disposée au niveau des extrémités longitudinales de la poutre. Dans cet exemple, les zones poreuses 410 414 sont localisées sur la partie mobile 304. Les parties d'actionnement et de mesure ne sont pas recouvertes de matériau poreux.

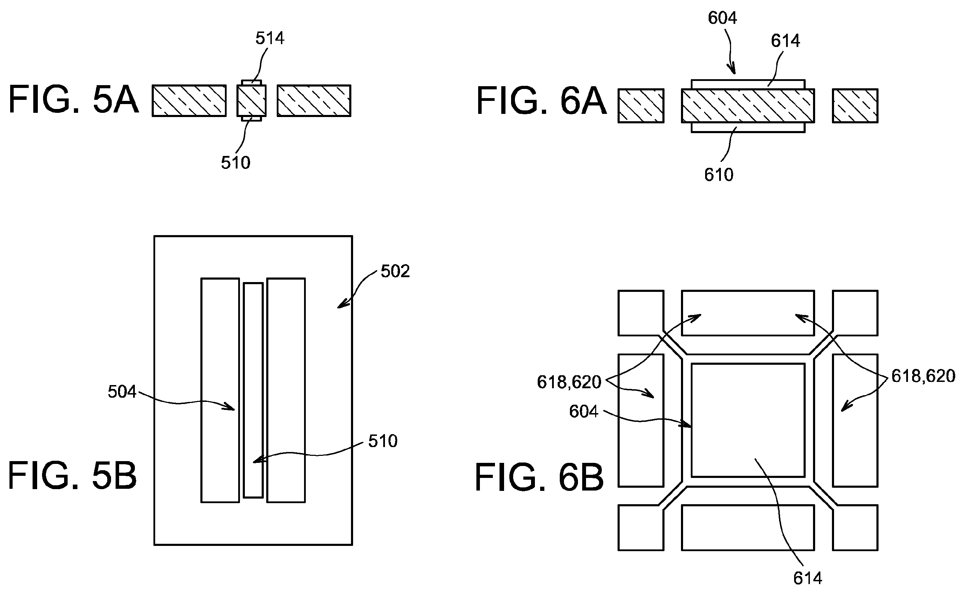

Sur les figures 5A et 5B, on peut voir une structure dans laquelle la partie libre 504 est du type poutre encastrée-encastrée au niveau de ses deux extrémités longitudinales sur la partie fixe 502, la poutre étant par exemple formée par un nanofil de type NEMS. Les moyens d'actionnement sont par exemple de type électrostatique comme ceux décrits pour la structure des figures 2A et 2B et les moyens de détection sont du type capacitif utilisant également des électrodes latérales. En variante, les moyens de détection peuvent être de type piézorésistif en utilisant directement les effets d'allongement et de rétrécissement du nanofil lors de ses mouvements latéraux, qui induisent des contraintes internes modifiant la résistance électrique du nanofil. Dans cet exemple, la zone poreuse est localisée au nanofil.

Sur les figures 6A et 6B, on peut voir un exemple de structure résonante à onde de volume de type "square plate", la partie mobile 604 étant formée par une plaque suspendue de forme parallélépipédique suspendue sur la partie fixe au niveau de ses quatre coins par des poutres.

Les moyens d'actionnement 618 sont par exemple de type électrostatique et les moyens de détection 620 sont par exemple de type capacitif, les électrodes étant situées au niveau des bords latéraux. Dans cet exemple, les zones poreuses 610, 614 sont localisées sur les faces inférieure et supérieure de la plaque suspendue 604.

Dans le cas d'une couche intercalaire en silicium monocristallin et des couches poreuses en silicium, le procédé selon l'invention permet de réaliser une structure offrant à la fois les avantages du silicium monocristallin comme matériau de la structure mécanique et les avantages d'une structure poreuse comme matériau d'interface avec le milieu environnant. En effet, le silicium monocristallin présente un module d'Young élevé, un facteur de qualité élevé pour les structures résonantes, il ne présente pas de contraintes intrinsèques, ni de phénomènes de fatigue. En outre sa fiabilité est démontrée dans le domaine des MEMS. Quant à la mise en oeuvre de couche poreuse, celle-ci permet d'augmenter la surface d'adsorption avec un milieu gazeux par exemple. De plus le silicium poreux n'introduit pas de contraintes résiduelles significatives ce qui permet de le mettre en oeuvre relativement facilement sur des structures mécaniques libérées sans introduire de déformations indésirables.

Dans le cas d'une structure dans laquelle les moyens d'actionnement et/ou de détection seraient de type capacitif, les électrodes peuvent être situées sur le substrat en regard de la face inférieure de la partie mobile, et grâce au procédé selon l'invention, il est possible de ne pas recouvrir celle-ci de matériau poreux en localisant différemment la couche poreuse sur la surface inférieure et sur la surface supérieure.

Grâce à l'invention, la surface d'adsorption formée par les couches poreuses est maximisée par rapport à l'état de la technique puisque le procédé selon l'invention permet de réaliser ces couches sur les faces inférieure et supérieure de tout ou partie de la structure mécanique, la sensibilité est donc accrue, par exemple pour des capteurs d'humidité, capteurs chimiques ou biologiques... tout en conservant des propriétés mécaniques du silicium monocristallin.

En outre, le procédé selon l'invention permet de localiser les zones poreuses sur la structure mécanique uniquement sur les parties utiles, et ainsi de ne pas former de porosité au niveau des moyens d'actionnement, par exemple les faces latérales en regard dans le cas d'un actionnement électrostatique par exemple comme cela a été décrit avec les exemple de structures des figures 2A à 6B ou au niveau des moyens de transduction, tels que les jauges piézorésistives par exemple (figures 2A à 4B). En effet la porosification du silicium entraîne une modification de ses caractéristiques (diminution du module d'Young, augmentation de l'isolation thermique, diminution de la conductivité électrique...) qui n'est en général pas souhaitable pour une grande partie de la structure mécanique. De même, il peut être préférable d'éviter de former des zones poreuses sur les surfaces se déformant pour éviter un accroissement des phénomènes de dissipation pouvant détériorer le facteur de qualité d'une structure résonante. De plus, le procédé selon l'invention permet éventuellement de localiser différemment les zones poreuses sur les surfaces supérieures et inférieures, ce qui présente les intérêts déjà mentionnés d'optimiser la qualité cristalline du matériau intercalaire dans certaines zones ou encore d'éviter d'avoir une surface poreuse sur une électrode sous la structure mobile tout en maximisant la zone poreuse en surface de cette structure pour une plus grande interaction avec le milieu extérieur.

Enfin, en réalisant des zones poreuses sur les deux faces de la structure, on équilibre les éventuelles contraintes résiduelles existant dans la couche de silicium poreux, pouvant induire une éventuelle courbure parasite de la structure mobile si une seule des faces était poreuse.

Il sera compris que les avantages énoncés ci-dessus sont également présents dans d'une structure mécanique comportant un empilement de deux couches poreuses de part et d'autre d'un matériau intercalaire, l'une des couches, deux de ces couches ou les trois couches n'étant pas nécessairement à base de silicium. Le matériau de la couche intercalaire est néanmoins choisi pour présenter de bonnes propriétés mécaniques.

Le procédé de fabrication selon l'invention permet de fabriquer des dispositifs de type MEMS et/ou NEMS pour tout type d'application, en particulier tout type de capteur destiné à adsorber des espèces d'intérêt comme par exemple les capteurs d'humidité, les capteurs chimiques, les capteurs biologiques, des systèmes de spectrométrie de masse utilisant des NEMS. Au delà, ce procédé peut être mis en oeuvre sur n'importe quelle structure sur laquelle une couche poreuse est mise en oeuvre pour ses propriétés d'adsorption mais encore ses propriétés thermiques et/ou électriques particulières.

Le procédé de fabrication selon l'invention peut être utilisé dans la fabrication de colonnes de chromatographie en phase gazeuse intégrant des MEMS.

## Revendications

1. Procédé de fabrication d'une structure micromécanique et/ou nanomécanique comportant les étapes suivantes, à partir d'un élément comportant un substrat support (2) et une couche sacrificielle (4) :
a) formation d'une première couche (6) dont au moins une partie (10) est poreuse,
b) formation, sur la première couche, d'une couche (12) assurant les propriétés mécaniques de la structure, dite couche intercalaire,
c) formation, sur la couche intercalaire, d'une deuxième couche dont au moins une partie (14) est poreuse,
d) formation de ladite structure dans l'empilement de la première couche, de la couche intercalaire et de la deuxième couche,
e) libération de ladite structure par retrait au moins partiel de la couche sacrificielle (4).

2. Procédé de fabrication selon la revendication 1, dans lequel la partie poreuse de la première couche se superpose au moins partiellement à la partie poreuse de la deuxième couche.

3. Procédé de fabrication selon la revendication 1 ou 2, dans lequel la première et / ou de la deuxième couche présente une porosité de type « ouverte ».

4. Procédé de fabrication selon l'une des revendications 1 à 3, dans lequel les matériaux des première et/ou la deuxième couches poreuses sont choisis indépendamment parmi les semi-conducteurs, les diélectriques; de préférence parmi les diélectriques à faible permittivité, le matériau de la première et/ou deuxième couche étant avantageusement un semi-conducteur dopé P ou de préférence P+.

5. Procédé de fabrication selon l'une quelconque des revendications 1 à 4, dans lequel l'étape a) et/ou l'étape c) comporte(nt) une étape de dépôt, de croissance ou de report d'une couche sur la couche sacrificielle et/ou sur la couche intercalaire.

6. Procédé de fabrication selon la revendication 5, dans lequel la partie poreuse de la première et/ou de la deuxième couche est localisée, la localisation étant obtenue par dépôt, croissance, report localisé ou par gravure localisée.

7. Procédé de fabrication selon la revendication 5 ou 6, dans lequel l'étape a) et/ou l'étape c) comporte(nt) une étape de porosification d'au moins une partie de ladite couche, l'étape de porosification étant avantageusement est obtenue par voie électrochimique (anodisation) ou par gravure en phase vapeur (stain-etching)

8. Procédé de fabrication selon la revendication 7, dans lequel préalablement à l'étape de porosification est réalisée un masque sur ladite couche de sorte à localiser au moins une zone de matériau à rendre poreuse.

9. Procédé de fabrication selon l'une des revendications 1 à 8, dans lequel l'étape b) comporte l'étape de croissance épitaxiale de la couche intercalaire sur la première couche.

10. Procédé de fabrication selon l'une quelconque des revendications 1 à 9, dans lequel l'étape d) de formation de ladite structure dans l'empilement de la première couche, de la couche intercalaire et de la deuxième couche comporte une étape de lithographie et de gravure anisotrope dudit empilement.

11. Procédé de fabrication selon l'une des revendications 1 à 10, dans lequel la première et la deuxième couche sont en silicium poreux et la couche intercalaire est en silicium monocristallin, ou la première et la deuxième couche sont en SiGe poreux et la couche intercalaire est en SiGe non poreux, ou la première et la deuxième couche sont en SiC poreux et la couche intercalaire est en SiC non poreux.

12. Procédé de fabrication selon l'une des revendications 1 à 11, dans lequel la structure comporte une partie fixe et une partie suspendue sur un support et des moyens d'actionnement de la partie suspendue et des moyens de détection du déplacement de la partie suspendue, la partie suspendue étant munie sur une première face en regard du support et sur une deuxième face opposée à la première face de au moins une zone poreuse formées lors des étapes a) et c).

13. Procédé de fabrication selon la revendication 12, dans lequel :
- les moyens d'actionnement sont électrostatiques et comportent des électrodes situées sur des flancs des parties fixes et suspendues non munis de zone poreuse, et/ou
- les moyens de détection et comportent des électrodes situées sur des flancs des parties fixes et suspendues non munis de zone poreuse, formant des moyens de détection capacitifs ou les moyens de détection comportent des jauges piézorésistives s'étendant entre la partie fixe et la partie suspendue, lesdites jauges n'étant pas munies de zone poreuse.

14. Procédé de fabrication selon la revendication 12 ou 13, dans lequel on forme en outre une ou plusieurs couches poreuses latérales sur des flancs de la partie suspendue et/ou de la partie fixes.

15. Procédé de fabrication selon l'une des revendications 1 à 14, dans lequel la structure micromécanique et/ou nanomécanique est destinée à la fabrication d'un capteur chimique et/ou biologique, et/ou d'humidité les zones poreuses étant destinées à adsorber des molécules d'intérêt.

## Patentansprüche

1. Verfahren zur Herstellung einer mikromechanischen und/oder nanomechanischen Struktur, umfassen die folgenden Schritte ausgehend von einem Element, das ein Trägersubstrat (2) und eine Opferschicht (4) umfasst:
a) Bilden einer ersten Schicht (6), von der wenigstens ein Teil (10) porös ist,
b) Bilden, auf der ersten Schicht, einer Schicht (12), die die mechanischen Eigenschaften der Struktur sicherstellt, genannt Zwischenschicht,
c) Bilden, auf der Zwischenschicht, einer zweiten Schicht, von der wenigstens ein Teil (14) porös ist,
d) Bilden der Struktur in dem Stapel aus der ersten Schicht, der Zwischenschicht und der zweiten Schicht,
e) Freilegen der Struktur durch wenigstens teilweises Entfernen der Opferschicht (4).

2. Verfahren zur Herstellung nach Anspruch 1, bei dem der poröse Teil der ersten Schicht wenigstens teilweise dem porösen Teil der zweiten Schicht überlagert ist.

3. Verfahren zur Herstellung nach Anspruch 1 oder 2, bei dem die erste und/oder die zweite Schicht eine Porosität vom "offenen" Typ aufweist.

4. Verfahren zur Herstellung nach einem der Ansprüche 1 bis 3, bei dem die Materialien der ersten und/oder der zweiten porösen Schicht unabhängig voneinander ausgewählt sind aus den Halbleitern, den Dielektrika; vorzugsweise aus den Dielektrika mit geringer Permittivität, wobei das Material der ersten und/oder der zweiten Schicht vorzugsweise ein P- oder bevorzugt P+-dotierter Halbleiter ist.

5. Verfahren zur Herstellung nach einem der Ansprüche 1 bis 4, bei dem der Schritt a) und/oder der Schritt c) einen Schritt des Abscheidens, des Aufwachsens oder des Übertragens einer Schicht auf die Opferschicht und/oder auf die Zwischenschicht umfasst/umfassen.

6. Verfahren zur Herstellung nach Anspruch 5, bei dem der poröse Teil der ersten und/oder der zweiten Schicht lokalisiert ist, wobei die Lokalisierung durch lokalisiertes Abscheiden, Aufwachsen oder Übertragen oder durch lokalisiertes Gravieren erzielt wird.

7. Verfahren zur Herstellung nach Anspruch 5 oder 6, bei dem der Schritt a) und/oder der Schritt c) einen Schritt des Porosifizierens wenigstens eines Teils der Schicht umfasst/umfassen, wobei der Schritt des Porosifizierens vorzugsweise erzielt wird auf elektrochemischem Weg (Anodisieren) oder durch Dampfphasengravur (stain-etching).

8. Verfahren zur Herstellung nach Anspruch 7, bei dem vor dem Schritt des Porosifizierens eine Maske auf der Schicht derart realisiert wird, dass wenigstens eine porös zu machende Materialzone lokalisiert wird.

9. Verfahren zur Herstellung nach einem der Ansprüche 1 bis 8, bei dem der Schritt b) den Schritt des epitaxialen Aufwachsens der Zwischenschicht auf der ersten Schicht umfasst.

10. Verfahren zur Herstellung nach einem der Ansprüche 1 bis 9, bei dem der Schritt d) des Bildens der Struktur in dem Stapel aus der ersten Schicht, der Zwischenschicht und der zweiten Schicht einen Schritt der Lithographie und der anisotropen Gravur des Stapels umfasst.

11. Verfahren zur Herstellung nach einem der Ansprüche 1 bis 10, bei dem die erste und die zweite Schicht aus porösem Silicium sind, und die Zwischenschicht aus monokristallinem Silicium ist, oder bei dem die erste und die zweite Schicht aus porösem SiGe sind und die Zwischenschicht aus nicht-porösem SiGe ist, oder bei dem die erste und die zweite Schicht aus porösem SiC sind und die Zwischenschicht aus nicht-porösem SiC ist.

12. Verfahren zur Herstellung nach einem der Ansprüche 1 bis 11, bei dem die Struktur einen festen Teil und einen aufgehängten Teil auf einem Träger umfasst, sowie Mittel zur Betätigung des aufgehängten Teils und Mittel zur Erfassung der Verlagerung des aufgehängten Teils, wobei der aufgehängte Teil auf einer ersten Seite gegenüber dem Träger und auf einer zweiten Seite entgegengesetzt zur ersten Seite mit wenigstens einer porösen Zone ausgestattet ist, die während der Schritte a) und c) gebildet wird.

13. Verfahren zur Herstellung nach Anspruch 12, bei dem:
- die Betätigungsmittel elektrostatisch sind und Elektroden umfassen, die auf Flanken des festen und des aufgehängten Teils gelegen sind, welche nicht mit einer porösen Zone ausgestattet sind, und/oder
- die Erfassungsmittel Elektroden umfassen, die auf Flanken des festen und des aufgehängten Teils gelegen sind, welche nicht mit einer porösen Zone ausgestattet sind, und kapazitive Erfassungsmittel bilden, oder die Erfassungsmittel piezoresistive Messplättchen umfassen, die sich zwischen dem festen Teil und dem aufgehängten Teil erstrecken, wobei die Messplättchen nicht mit einer porösen Zone ausgestattet sind.

14. Verfahren zur Herstellung nach Anspruch 12 oder 13, bei dem man ferner eine oder mehrere laterale poröse Schichten auf den Flanken des aufgehängten Teils und/oder des festen Teils bildet.

15. Verfahren zur Herstellung nach einem der Ansprüche 1 bis 14, bei dem die mikromechanische und/oder nanomechanische Struktur zur Herstellung eines chemischen und/oder biologischen Sensors und/oder eines Feuchtigkeitssensors ausgelegt ist, wobei die porösen Zonen dazu ausgelegt sind, Moleküle von Interesse zu adsorbieren.

## Claims

1. Process for fabrication of a micromechanical and/or nanomechanical structure comprising the following steps, starting from an element comprising a support substrate (2) and a sacrificial layer (4):
a) formation of a first layer (6), at least part (10) of which is porous,
b) formation on the first layer of a layer (12) providing the mechanical properties of the structure, called the intermediate layer,
c) formation on the intermediate layer of a second layer, at least part (14) of which is porous,
d) formation of said structure in the stack composed of the first layer, the intermediate layer and the second layer,
e) release of said structure by at least partial removal of the sacrificial layer (4).

2. Fabrication process according to claim 1, in which the porous part of the first layer is at least partially superposed on the porous part of the second layer.

3. Fabrication process according to claim 1 or 2, in which the first layer and/or the second layer has an open type porosity.

4. Fabrication process according to claims 1 to 3, in which the materials in the first and/or second porous layers are chosen independently among semiconductors, dielectrics, preferably among low permittivity dielectrics, the material of the first and/or second layer being advantageously made is a P-dope or preferably P+-doped.

5. Fabrication process according to claims 1 to 4, in which step a) and/or step c) comprise a step for the deposition, growth or transfer of a layer onto the sacrificial layer and/or the intermediate layer.

6. Fabrication process according to claim 5, in which the porous part of the first and/or the second layer is localised, the localisation being achieved by localised deposition, growth, transfer or localised etching.

7. Fabrication process according to claim 5 or 6, in which step a) and/or step c) comprise a step to porosify at least one part of said layer, the porosification being advantageously achieved electrochemically or by stain etching.

8. Fabrication process according to claim 7, in which a mask is made on said layer before the porosification step is done, so as to localise at least one zone of material to be made porous.

9. Fabrication process according to one of claims 1 to 8, in which step b) comprises the step for epitaxial growth of the intermediate layer on the first layer.

10. Fabrication process according to one of claims 1 to 9, in which step d) in which said structure is formed in the stack composed of the first layer, the intermediate layer and the second layer comprises a lithography and anisotropic etching step of said stack.

11. Fabrication process according to one of claims 1 to 10, in which the first and second layers are made of porous silicon and the intermediate layer is made of monocrystalline silicon or the first and second layers are made of porous SiGe and the intermediate layer is made of non-porous SiGe, or the first and second layers are made of porous SiC and the intermediate layer is made of non-porous SiC.

12. Fabrication process according to one of claims 1 to 11, in which the structure comprises a fixed part and a suspended part on a support and means of actuating the suspended part and means of detecting displacement of the suspended part, the suspended part being provided with at least one porous zone formed during steps a) and c) on its first face facing the support and its second face opposite the first face.

13. Fabrication process according to claim 12, in which:
- the actuation means are electrostatic and comprise electrodes located on flanks of the fixed and suspended parts without any porous zone, and/or
- the detection means comprise electrodes located on flanks of the fixed and suspended parts without any porous zone, forming capacitive detection means or the detection means comprise piezoresistive gauges extending between the fixed part and the suspended part, said gauges not being provided with a porous zone.

14. Fabrication process according to claim 12 or 13, in which one or several porous lateral layers are also formed on flanks of the suspended part and/or the fixed part.

15. Fabrication process according to one of claims 1 to 14, in which the micromechanical and/or nanomechanical structure is used for fabrication of a chemical and/or biological sensor, and/or a humidity sensor, the porous zones being designed to adsorb molecules of interest.
